# EUROPEAN PATENT APPLICATION

(11) **EP 3 767 665 A1**
(43) Date of publication of application: **20.01.2021**
(21) Application number: 19767046.6
(22) Date of filing: 26.02.2019
(51) Int. Cl.: H01L 21/304, B08B 3/04, H01L 21/683

(54) **WAFER TREATMENT DEVICE AND TREATMENT METHOD**

(30) Priority: 13.03.2018 JP 2018046043
(71) Applicant: Shin-Etsu Handotai Co., Ltd., Tokyo 100-0004 (JP)
(72) Inventor: IGARASHI Kensaku, Nishishirakawa-gun, Fukushima 961-8061 (JP); ABE Tatsuo, Nishishirakawa-gun, Fukushima 961-8061 (JP)
(74) Representative: Wibbelmann, Jobst
(86) International application number: PCT/JP2019/007375
(87) International publication number: WO 2019/176531

(57) **Abstract**

The present invention is a wafer treatment apparatus provided with a rotatable table inside a chamber and a plurality of holding pins arranged on the table, where a periphery of a wafer is held by the plurality of holding pins and the wafer is subjected to a cleaning and/or drying treatment while being rotated, where one or more of the plurality of holding pins are drivable, and press and hold the wafer so that a resultant force working on the held wafer works in a direction that bends the wafer upwards in a convex shape. This provides a wafer treatment apparatus and a method for treating a wafer that can prevent particles from aggregating in a wafer rotation center and prevent dry marks, etc. from occurring.

## Description

### TECHNICAL FIELD

The present invention relates to a wafer treatment apparatus and a method for treating a wafer.

### BACKGROUND ART

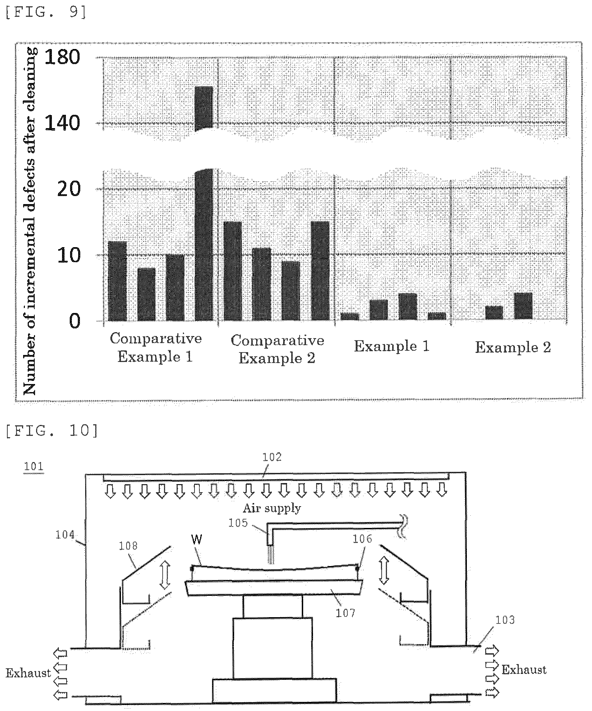

A wafer treatment apparatus 101 shown in FIG. 10 is known as an apparatus for subjecting a wafer to a cleaning and/or drying treatment. The wafer treatment apparatus 101 features: a chamber 104 provided with an air supply unit 102 for supplying air and an exhaust unit 103 for exhausting air; a nozzle unit 105 having a nozzle head (nozzle block) for supplying a chemical solution; a table 107 that is provided with a plurality of holding pins 106 and that holds and rotates a periphery of a wafer W; a cup unit 108 that can be raised or lowered for collecting or discharging a scattered chemical solution; and the like (for example, Patent Document 1).

A cleaning or drying treatment is performed while holding and rotating the wafer W using such a treatment apparatus 101.

### CITATION LIST

### PATENT LITERATURE

Patent Document 1: Japanese Unexamined Patent Application Publication No. 2008-060107

### SUMMARY OF INVENTION

### TECHNICAL PROBLEM

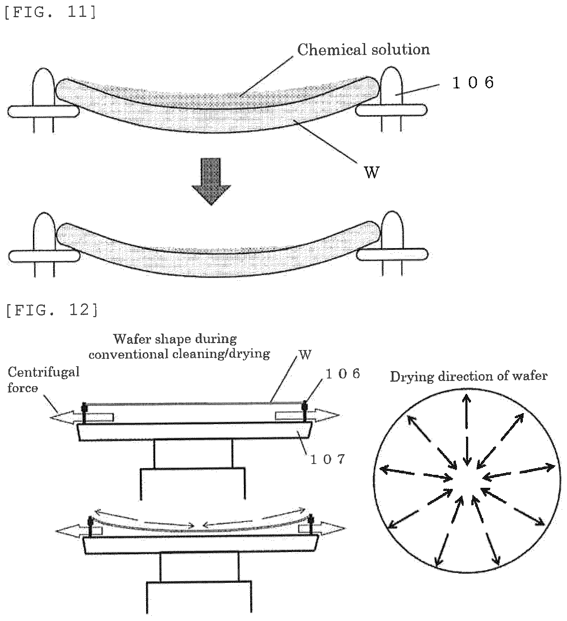

In recent years, as the diameter of a wafer increases, the wafer's own weight increases, and a wafer W held in a periphery by holding pins 106 always becomes dented in the central part in a concave shape (downward convex shape) to some extent in a cleaning or drying treatment (see FIG. 11).

However, this has been thought of as unavoidable, and deformation of a wafer into a concave shape during a treatment has not been taken into consideration in a conventional apparatus for subjecting a wafer to a cleaning and drying treatment.

Furthermore, a conventional treatment apparatus generally has a structure that raises the Bernoulli effect to prevent the wafer from flying off while cleaning, and if the gap between the wafer and a table is made narrow in order to raise the Bernoulli effect, the gap between the wafer and the table comes to have a negative pressure, so that the wafer is even more liable to become deformed into a concave shape (see FIG. 12).

Here, when drying the wafer, the wafer is dried by scattering a chemical solution by a centrifugal force. If the wafer has a concave shape when drying after cleaning, the centrifugal force around the center is weak, and since there is a tilt towards the center of the wafer, the chemical solution on the wafer comes to be collected in the center. Hence, there is a problem that the drying begins at the outermost periphery or near the periphery of the wafer, and the center is dried last (see FIG. 11 and FIG. 12).

In a case where micro particles, etc. are contained in the solution, the particles collect in the center of the wafer, or dry marks occur if the wafer is dried from the periphery towards the center.

The present invention has been made to solve the above-described problem, and an object thereof is to provide a wafer treatment apparatus and a method for treating a wafer that can prevent particles from aggregating in a wafer rotation center and prevent dry marks, etc. from occurring.

### SOLUTION TO PROBLEM

To achieve the object, the present invention provides a wafer treatment apparatus provided with a rotatable table inside a chamber and a plurality of holding pins arranged on the table, where a periphery of a wafer is held by the plurality of holding pins and the wafer is subjected to a cleaning and/or drying treatment while being rotated, wherein one or more of the plurality of holding pins are drivable, and press and hold the wafer so that a resultant force working on the held wafer works in a direction that bends the wafer upwards in a convex shape.

Such a wafer treatment apparatus allows deformation of the shape of the wafer into an upward convex shape during the cleaning and drying treatments, and therefore, can prevent particles from aggregating in a wafer rotation center after a treatment and prevent dry marks, etc. from occurring.

A space between an upper surface of the rotatable table and a lower surface of the held wafer is preferably 20 mm or more in a stationary state.

In this manner, the Bernoulli effect can be suppressed even when the wafer is rotated, and the wafer can be bent upwards in a convex shape more easily.

In addition, the one or more drivable holding pins can be drivable further inwards than a radius of the wafer.

In this manner, the wafer can be pressed sufficiently even when the wafer has been deformed into a convex shape, and therefore, the wafer can be held more steadily.

Furthermore, the one or more drivable holding pins can be driven in a rotational movement mode or a horizontal movement mode.

The movement mode of the holding pins in the present invention can be selected appropriately from such movement modes.

Furthermore, the plurality of holding pins preferably have a tip shape having a tilted portion for pushing a chamfered portion of the wafer and a vertical portion for pushing a side of the wafer horizontally.

With such a shape, there is no dislocation even when the wafer is pressed, and the wafer can be held more steadily with an upward convex shape.

In addition, two or more of the plurality of holding pins are preferably fixed.

When the holding pins include such a number of fixed pins, the wafer can be held more steadily, and occurrence of turbulence when rotating can be suppressed further.

Furthermore, the plurality of holding pins preferably press and hold the wafer at a pressure of 5.0 N or more and 30.0 N or less.

A pressure within such a range allows the wafer to be held more steadily as an upward convex, and cracking of the wafer can be further suppressed.

In addition, the present invention provides a method for treating a wafer where a periphery of a wafer is held inside a chamber by a plurality of holding pins arranged on a rotatable table and the wafer is subjected to a cleaning and/or drying treatment while being rotated, wherein the wafer is pressed and held by driving one or more of the plurality of holding pins so that a resultant force working on the wafer works in a direction that bends the wafer upwards in a convex shape and the held wafer is deformed upwards into a convex shape and subjected to a cleaning and/or drying treatment while being rotated by rotating the rotatable table.

In this manner, the wafer is deformed upwards into a convex shape and subjected to a cleaning and/or drying treatment in the inventive method for treating a wafer, and therefore, particles can be prevented from aggregating in the wafer rotation center after a treatment and occurrence of dry marks, etc. can be prevented.

Furthermore, the wafer is preferably arranged and held so that a space between an upper surface of the rotatable table and a lower surface of the wafer is 20 mm or more in a stationary state.

In this manner, it is possible to suppress the Bernoulli effect even when the wafer is rotated, and to bend the wafer upwards in a convex shape more easily.

In addition, the wafer can be pressed and held by driving the one or more of the plurality of holding pins in a rotational movement mode or a horizontal movement mode.

A movement mode can thus be selected appropriately to drive the one or more holding pins.

In addition, the wafer is preferably pressed and held by applying a pressure of 5.0 N or more and 30.0 N or less.

The wafer can be held more steadily in an upward convex shape with such a pressure range, and the wafer can be better suppressed from cracking.

### ADVANTAGEOUS EFFECTS OF INVENTION

As described above, the shape of the wafer during a treatment can be made to be an upward convex shape by the inventive wafer treatment apparatus and method for treating a wafer, and therefore, aggregation of particles in a wafer rotation center after a treatment can be prevented, and occurrence of dry marks, etc. can be prevented.

### BRIEF DESCRIPTION OF DRAWINGS

FIG. 1 is a schematic view showing an example of the inventive wafer treatment apparatus.
FIG. 2 is a schematic view showing the shape of a wafer while cleaning and drying in the inventive wafer treatment apparatus.
FIG. 3 is a diagram for explaining a method by which a wafer can be bent upwards in a convex shape. (A) to (C) are examples in which the wafer cannot be bent upwards in a convex shape, and (D) is an example in which the wafer can be bent upwards in a convex shape.
FIG. 4 is a side view and a top view showing an example of shapes of holding pins that can be used in the inventive wafer treatment apparatus.
FIG. 5 is a schematic view showing driving modes of drivable holding pins in the inventive wafer treatment apparatus.
FIG. 6 is a top view showing an example of the number of holding pins and arrangement thereof when holding a wafer in the inventive wafer treatment apparatus.
FIG. 7 is a schematic view showing the shapes of the holding pins used in the Examples and Comparative Examples.
FIG. 8 is a schematic view showing the shape of a wafer and the drying direction of the wafer in the Examples.
FIG. 9 is a graph showing the number of incremental defects after a drying treatment in the Examples and Comparative Examples.
FIG. 10 is a schematic view showing an example of a conventional wafer treatment apparatus.
FIG. 11 is an enlarged schematic view of a held wafer in a conventional wafer treatment apparatus.
FIG. 12 is a schematic view showing the shape of a wafer and the drying direction of the wafer due to the Bernoulli effect in a conventional wafer treatment apparatus.

### DESCRIPTION OF EMBODIMENTS

As described above, development of a wafer treatment apparatus and a method for treating a wafer have been desired by which particles can be prevented from aggregating in a wafer rotation center and dry marks, etc. can be prevented from occurring.

The present inventors have earnestly studied the above problem and found that by deforming the shape of a wafer during a treatment into an upward convex shape, the wafer can be dried on an entire surface or drying can be started from the central part rather than from a periphery, and completed the present invention.

That is, the present invention is a wafer treatment apparatus provided with a rotatable table inside a chamber and a plurality of holding pins arranged on the table, where a periphery of a wafer is held by the plurality of holding pins and the wafer is subjected to a cleaning and/or drying treatment while being rotated, wherein one or more of the plurality of holding pins are drivable, and press and hold the wafer so that a resultant force working on the held wafer works in a direction that bends the wafer upwards in a convex shape.

In addition, the present invention is a method for treating a wafer where a periphery of a wafer is held inside a chamber by a plurality of holding pins arranged on a rotatable table and the wafer is subjected to a cleaning and/or drying treatment while being rotated, wherein the wafer is pressed and held by driving one or more of the plurality of holding pins so that a resultant force working on the wafer works in a direction that bends the wafer upwards in a convex shape and the held wafer is deformed upwards into a convex shape and subjected to a cleaning and/or drying treatment while being rotated by rotating the rotatable table.

Hereinafter, the present invention will be described in detail, but the present invention is not limited thereto.

### [Wafer Treatment Apparatus]

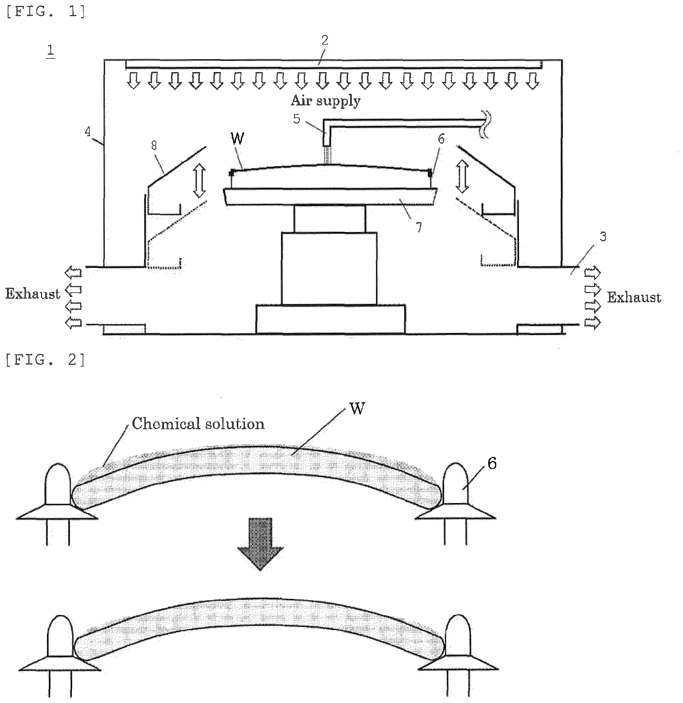

Firstly, the inventive wafer treatment apparatus will be described. FIG. 1 is a schematic view showing an example of a wafer treatment apparatus in the present invention.

The wafer treatment apparatus 1 is provided with, for example, a chamber 4 provided with an air supply unit 2 for supplying air and an exhaust unit 3 for exhausting air, a nozzle unit 5 for supplying a chemical solution, and a cup unit 8 that can be raised or lowered for collecting or discharging a scattered chemical solution. The wafer treatment apparatus 1 can hold the periphery of the wafer W to be treated with a plurality of holding pins 6 arranged on a table 7 that is rotationally driven, and subject the wafer W to a cleaning and/or drying treatment while rotating the wafer W.

In the inventive wafer treatment apparatus 1, one or more of the plurality of holding pins 6 are drivable and can press and hold the wafer W so that the resultant force working on the held wafer W works in a direction that bends the wafer upwards in a convex shape. As shown in FIG. 2, the wafer W can be cleaned and dried with an upward deformation in a convex shape when the inventive wafer treatment apparatus 1 is used, and the chemical solution on the wafer can be sent off to the periphery of the wafer.

The method for pressing and holding the wafer is not particularly limited as long as the wafer can be bent upwards in a convex shape, but the following is possible, for example.

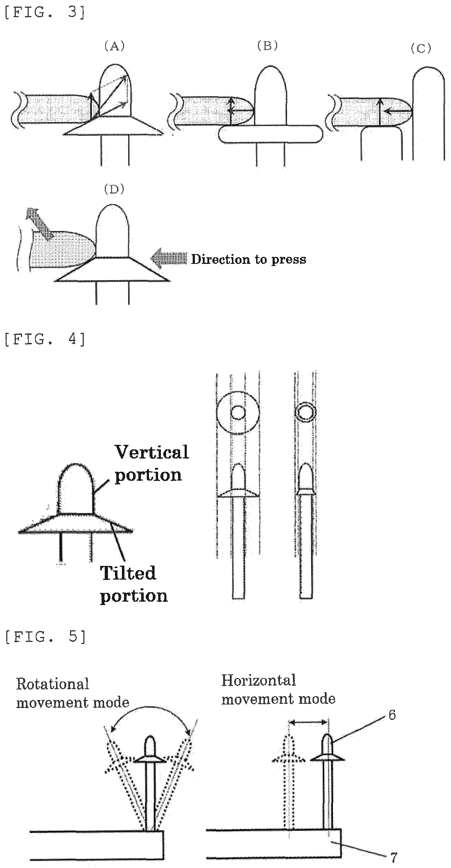

FIG. 3 is a diagram for explaining an example of a method for bending a wafer upwards in a convex shape. In order to deform the wafer upwards into a convex shape, a force (a force for bending the wafer W upwards in a convex shape) for holding the wafer diagonally upwards towards the wafer center is applied on either side of the wafer. When holding pins that can hold a beveled portion (chamfered portion) of the wafer as shown in FIG. 3 (A) are used, a diagonally upward force towards the wafer center is not generated unless a force for holding the wafer in a lateral direction of the wafer is applied. Likewise, if holding pins that hold the bottom and a side of the wafer as shown in FIG. 3 (B) and (C) are used, a diagonally upward force towards the wafer center is not generated.

Accordingly, when the shape of the holding pins 6 is such that the holding pins can come into contact, not only with the side of the wafer, but also the beveled part, for example, as shown in FIG. 3 (D), and a force is applied towards the wafer center to hold the wafer W, the wafer W can be bent upwards in a convex shape.

In the present invention, a tip shape of the holding pins 6 is not particularly limited as long as the wafer W can be bent upwards in a convex shape, but the tip shape preferably has a structure having a tilted portion for pushing the beveled portion of the wafer W and a vertical portion for pushing the side of the wafer W horizontally as shown in FIG. 4. Furthermore, the tip shape may also have a contact portion for pushing the wafer W from the side. When such holding pins 6 are used, there is no danger of the wafer W being shifted upwards even when a diagonally upward force towards the wafer center is applied. In addition, when the holding pins 6 have a tilted portion, the size of the tilted portion (umbrella-shaped part) is not particularly limited, but the tilted portion preferably has a diameter of 3.0 mm or more and 20.0 mm or less. Within this range, the wafer can be held sufficiently, and there is no danger of a turbulence occurring when the wafer is rotated.

Furthermore, the one or more drivable holding pins 6 can be drivable further inwards than a radius of the wafer W. With such holding pins, the wafer W can be pressed sufficiently when mounting the wafer W and also when the wafer W has become upwardly convex shaped and the wafer radius has shrunk, and the wafer W can be held bent upwards in a convex shape more easily.

Furthermore, with a position at which the one or more drivable holding pins 6 just come into contact with the wafer when mounting set as a zero point, the one or more drivable holding pins 6 may have a range of motion of 1 to 10 mm towards the wafer W center side. In addition, the one or more drivable holding pins 6 can preferably be moved approximately 1 mm to 10 mm from the zero point in an outward direction of the table 7 when mounting the wafer W. With such a range of motion, there is no danger of the wafer W deforming too much and cracking, and the wafer can be carried in and out easily since there is no danger of contact when placing the wafer W.

In addition, as shown in FIG. 5, the driving mode of the one or more drivable holding pins 6 can be selected appropriately from two types: rotational movement mode; and horizontal movement mode.

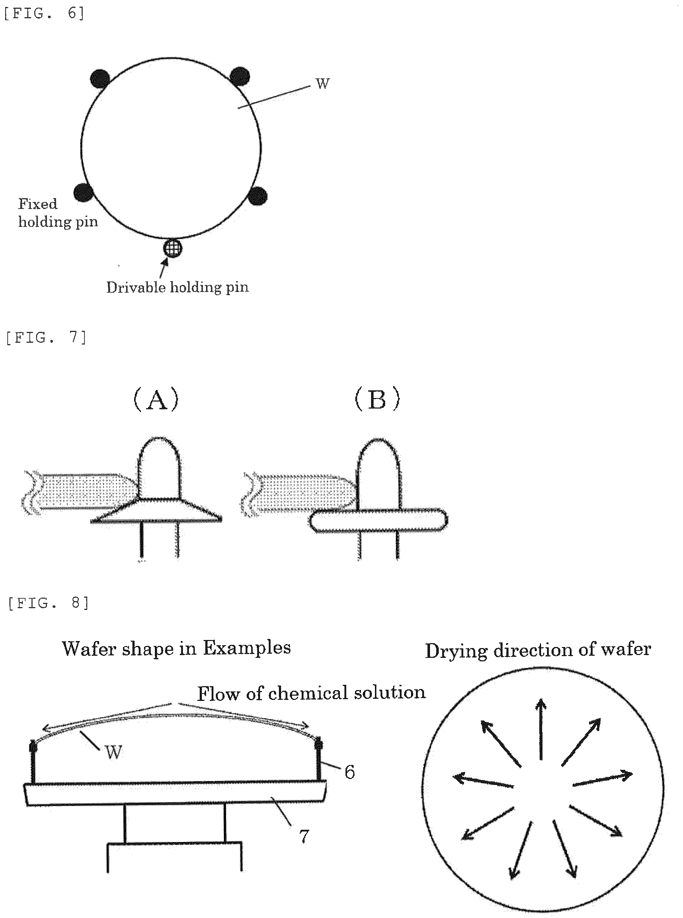

In addition, as shown in FIG. 6, two or more and five or fewer of the holding pins 6 are preferably fixed when placing the wafer W. When the number of holding pins 6 is so, the wafer W can be held sufficiently and there is no danger of turbulence occurring when the wafer W is rotated.

Furthermore, the pressure at which the holding pins 6 press the wafer W is preferably 5.0 N or more and 30.0 N or less. Within such a pressure range, the wafer W can be held more steadily in an upward convex shape, and there is no danger of the wafer W cracking.

The material of the holding pins 6 where they come into contact with the wafer W is not particularly limited, but examples thereof include resins and the like such as polyimide, polyethylene, polypropylene, p-xylene, PTFE (polytetrafluoroethylene), PFA (tetrafluoroethylene-perfluoroalkylvinylether copolymer), daiflon (TTCFE) (Teflon (registered trade mark)), PEEK (polyetheretherketone resin), and PVC (polyvinyl chloride).

In addition, a core material for the holding pins 6 is not particularly limited, but examples thereof include a metal member such as SUS (stainless steel) or super steel coated with a resin or the like such as polyimide, polyethylene, polypropylene, p-xylene, PTFE, PFA, daiflon (TTCFE) (Teflon (registered trade mark)), PEEK, and PVC, or coated with DLC (diamond-like carbon).

In addition, the space between the upper surface of the rotatable table 7 and the lower surface of the held wafer W is preferably 20 mm or more in a stationary state.

When the space between the lower surface of the wafer W and the upper surface of the table 7 is 10 mm or less, the pressure between the wafer W and the table 7 becomes a negative pressure compared with the pressure inside the chamber due to the Bernoulli effect, and the wafer W is more liable to become concave-shaped. Accordingly, the space between the lower surface of the wafer W and the upper surface of the table 7 is preferably larger than 10 mm, and particularly preferably 20 mm or more and 100 mm or less. Within such a range, the wafer W can be made into an upward convex shape more easily, and there is no danger of the holding pins 6 breaking.

In this manner, when drying the wafer, the wafer is dried by scattering the chemical solution by a centrifugal force, and since the wafer shape can be made into an upward convex shape in the inventive wafer treatment apparatus, the centrifugal force around the center is weak and there is a tilt towards the wafer periphery, so that the chemical solution, etc. on the wafer goes towards the periphery side. For this reason, the drying begins at the center at the time of drying, and even when micro particles or the like are contained in the solution, the micro particles can be sent off to the periphery, and dry marks also do not occur.

### [Method for Treating a Wafer]

Subsequently, the inventive method for treating a wafer will be described with an example using a case in which the above-described inventive wafer treatment apparatus 1 is used.

In the inventive method for treating a wafer, the periphery of the wafer W is held inside the chamber 4 by the plurality of holding pins 6 arranged on the rotatable table 7. In this event, the wafer W is pressed and held by driving one or more of the plurality of holding pins 6 so that the resultant force working on the wafer W works in a direction that bends the wafer upwards in a convex shape. This held wafer W is deformed upwards into a convex shape and subjected to a cleaning and/or drying treatment while being rotated by rotating the rotatable table 7.

In this event, the wafer W is preferably arranged and held so that the space between the upper surface of the rotatable table 7 and the lower surface of the wafer W is 20 mm or more in a stationary state. By arranging the wafer W in this manner, the Bernoulli effect can be made small, and the wafer W can be deformed upwards into a convex shape more easily.

In addition, the wafer W can be pressed and held by driving the one or more of the plurality of holding pins 6 in a rotational movement mode or a horizontal movement mode. As described, a movement mode can be selected appropriately to drive the one or more holding pins 6 in the inventive method for treating a wafer.

In this event, the wafer W is preferably pressed and held by applying a pressure of 5.0 N or more and 30.0 N or less. Within such a pressure range, the wafer W can be held more steadily in an upward convex shape, and there is no danger of the wafer W cracking.

### EXAMPLE

Hereinafter, the present invention will be specifically described with reference to Examples and Comparative Examples, but the present invention is not limited thereto.

### (Examples 1 and 2)

Using the inventive wafer treatment apparatus as shown in FIG. 1, four wafers with a diameter of 300 mm were each deformed into an upward convex shape under the conditions shown in Table 1, and cleaning and drying treatments were performed. The shape of the holding pins used in this event were as shown in FIG. 7. Note that as the method of cleaning, a general method of cleaning by repeatedly alternating between hydrofluoric acid and ozone water was performed, and as the chemical solution, pure water, a hydrofluoric acid with a concentration of 0.5 mass%, and an ozone water with a concentration of 20 ppm were used. In this event, the shape of the wafer and the drying direction in the Examples 1 and 2 came to be as shown in FIG. 8.

A same-point observation of the defects on the wafer before cleaning and after cleaning was carried out, and the number of incremental defects was evaluated. The evaluation was performed using a Surfscan SP5 manufactured by KLA-Tencor, and the number of defects with a particle size of 19 nm or more on the wafer was measured.

### (Comparative Examples 1 and 2)

The wafers were subjected to cleaning and drying treatments by the same procedures as in the Examples 1 and 2 except that the wafers were not deformed into an upward convex shape, and an evaluation was carried out. In this event, the shape of the wafer and the drying direction in the Comparative Examples 1 and 2 came to be as shown in FIG. 12, as is conventional.

**[Table 1]**

| | Shape of holding pins | Mode of pressing | Pressing pressure | Wafer shape |
|---|---|---|---|---|
| Comparative Example 1 | FIG. 7 (A) | Horizontal movement | 0 N | Downward convex |
| Comparative Example 2 | FIG. 7 (B) | Horizontal movement | 10 N | Downward convex |
| Example 1 | FIG. 7 (A) | Horizontal movement | 10 N | Upward convex |
| Example 2 | FIG. 7 (A) | Rotational movement | 10 N | Upward convex |

The results of the Examples and Comparative Examples have been summarized in FIG. 9. As shown in FIG. 9, in Example 1 and Example 2, the cleaning and the drying were performed with the wafer deformed upwards into a convex shape, and the chemical solution was spread to the periphery of the wafer during the cleaning and the drying, and therefore, increase in the number of defects resulting from remaining particles was hardly observed. Moreover, dry marks, etc. in the wafer rotation center did not occur, and the overall quality was favorable. On the other hand, in the Comparative Example 1 and Comparative Example 2, the cleaning and the drying were performed with the wafer shape in a downwardly-convex-shaped state as is conventional, and the chemical solution got gathered in the wafer rotation center. Increase in the number of defects resulting from remaining particles was remarkable, aggregation of remaining dry marks in the center occurred, and the quality was poor.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A wafer treatment apparatus provided with a rotatable table inside a chamber and a plurality of holding pins arranged on the table, where a periphery of a wafer is held by the plurality of holding pins and the wafer is subjected to a cleaning and/or drying treatment while being rotated, wherein
one or more of the plurality of holding pins are drivable, and press and hold the wafer so that a resultant force working on the held wafer works in a direction that bends the wafer upwards in a convex shape.

2. The wafer treatment apparatus according to claim 1, wherein a space between an upper surface of the rotatable table and a lower surface of the held wafer is 20 mm or more in a stationary state.

3. The wafer treatment apparatus according to claim 1 or 2, wherein the one or more drivable holding pins are drivable further inwards than a radius of the wafer.

4. The wafer treatment apparatus according to any one of claims 1 to 3, wherein the one or more drivable holding pins are driven in a rotational movement mode or a horizontal movement mode.

5. The wafer treatment apparatus according to any one of claims 1 to 4, wherein the plurality of holding pins have a tip shape having a tilted portion for pushing a chamfered portion of the wafer and a vertical portion for pushing a side of the wafer horizontally.

6. The wafer treatment apparatus according to any one of claims 1 to 5, wherein two or more of the plurality of holding pins are fixed.

7. The wafer treatment apparatus according to any one of claims 1 to 6, wherein the plurality of holding pins press and hold the wafer at a pressure of 5.0 N or more and 30.0 N or less.

8. A method for treating a wafer where a periphery of a wafer is held inside a chamber by a plurality of holding pins arranged on a rotatable table and the wafer is subjected to a cleaning and/or drying treatment while being rotated, wherein
the wafer is pressed and held by driving one or more of the plurality of holding pins so that a resultant force working on the wafer works in a direction that bends the wafer upwards in a convex shape and
the held wafer is deformed upwards into a convex shape and subjected to a cleaning and/or drying treatment while being rotated by rotating the rotatable table.

9. The method for treating a wafer according to claim 8, wherein the wafer is arranged and held so that a space between an upper surface of the rotatable table and a lower surface of the wafer is 20 mm or more in a stationary state.

10. The method for treating a wafer according to claim 8 or 9, wherein the wafer is pressed and held by driving the one or more of the plurality of holding pins in a rotational movement mode or a horizontal movement mode.

11. The method for treating a wafer according to any one of claims 8 to 10, wherein the wafer is pressed and held by applying a pressure of 5.0 N or more and 30.0 N or less.
